(19) **Europäisches Patentamt**
**European Patent Office**
**Office européen des brevets**

(11) **EP 3 905 321 A1**

(12) **EUROPEAN PATENT APPLICATION**
published in accordance with Art. 153(4) EPC

(43) Date of publication:
**03.11.2021 Bulletin 2021/44**

(21) Application number: **19906329.8**

(22) Date of filing: **24.12.2019**

(51) Int Cl.:
*H01L 23/427* (2006.01)          *F28D 15/02* (2006.01)
*H05K 7/20* (2006.01)

(86) International application number:
**PCT/JP2019/050599**

(87) International publication number:
**WO 2020/138081 (02.07.2020 Gazette 2020/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **27.12.2018 JP 2018245274**

(71) Applicant: **Kawasaki Jukogyo Kabushiki Kaisha
Hyogo 650-8670 (JP)**

(72) Inventors:
• **HARUKI, Yu**
  **Hyogo, 650-8670 (JP)**
• **SAKAGAWA, Keiji**
  **Hyogo, 650-8670 (JP)**
• **HAKAMADA, Kazuhide**
  **Hyogo, 650-8670 (JP)**
• **MITANI, Ryosuke**
  **Hyogo, 650-8670 (JP)**

(74) Representative: **Dehns
St. Bride's House
10 Salisbury Square
London EC4Y 8JD (GB)**

(54) **EVAPORATOR AND LOOP HEAT PIPE**

(57)     An evaporator that changes at least a part of a working fluid from a liquid phase into a gas phase by using heat of a heat-generating element includes: a housing including at least one working fluid inlet and at least one working fluid outlet and defining a working fluid-receiving chamber that receives the working fluid; a heat-absorbing element located at a bottom surface of the housing and thermally connected to the heat-generating element; and a wall structure rising from a boiling surface in the working fluid-receiving chamber and dividing a bottom region of the working fluid-receiving chamber into a plurality of segments to form a plurality of recesses located in the bottom region of the working fluid to trap the working medium.

FIG.8

**Description**

**Technical Field**

The present invention relates to an evaporator and a loop heat pipe including the evaporator.

**Background Art**

A loop heat pipe technology has been traditionally known which uses phase changes of a working fluid to achieve high-density heat transport. A heat transport system employing such a loop heat pipe has been used, for example, to cool an electronic device such as a computer or home electric appliance. In some loop heat pipes, the working fluid is circulated by means of capillary force and/or gravity.

A loop heat pipe includes a closed loop formed by an evaporator, a condenser, a vapor conduit leading from the evaporator to the condenser, and a liquid conduit leading from the condenser to the evaporator. The closed loop is charged with a working fluid. In the evaporator, the working fluid in a liquid phase is heated by heat transferred from a heat-generating element, and a part of the working fluid changes into a gas phase. The gas-liquid two-phase working fluid moves in the vapor conduit under the action of pressure difference and buoyancy and reaches the condenser. In the condenser, the working fluid is cooled into the liquid phase. The liquid-phase working fluid returns to the evaporator under the action of capillary force and/or gravity. In this manner, the loop heat pipe allows the working fluid to circulate in the two-phase closed loop and transport heat from the evaporator to the condenser, thereby cooling the heat-generating element thermally connected to the evaporator.

Patent Literature 1 proposes an evaporator for use in a loop heat pipe as described above, the evaporator including a wick located in a lower region of the evaporator. The pores of the wick are filled with a working fluid, and the liquid-phase working fluid remains in the evaporator even when the loop heat pipe is not in operation.

**Citation List**

**Patent Literature**

PTL 1: Japanese Patent No. 5741354

**Summary of Invention**

**Technical Problem**

Electronic devices have become more and more sophisticated and miniaturized, and this has recently led to a growing demand for thermal management in transportation machines such as watercrafts, railcars, automobiles, and aircrafts which are equipped with a large number of the sophisticated, miniaturized devices. Some transportation machines incorporate a heat transport system including a loop heat pipe as described above which uses gravity for circulation of a working fluid, and such a transportation machine, the position of the body of which constantly changes, suffers a position change-induced decrease in the drive force for allowing the working fluid to circulate and a corresponding decrease in the heat transport rate.

In the case of an evaporator including a heat-absorbing element located at the bottom of the evaporator and thermally connected to a heat-generating element, tilting of the evaporator is expected to lead to a part of the heat-absorbing element not being in contact with the working fluid. In the dry portions of the heat-absorbing element that are not in contact with the working fluid, the liquid-phase working fluid does not evaporate. Thus, the amount of heat absorption is smaller in the dry portions than in the rest, i.e., the wet portions, of the heat-absorbing element.

The present invention has been made in view of the above circumstances, and an object of the present invention is to provide an evaporator including a heat-absorbing element located at the bottom of the evaporator and thermally connected to a heat-generating element and a loop heat pipe including the evaporator, the evaporator and loop heat pipe being adapted to efficiently cool the heat-generating element in contact with the heat-absorbing element despite changes in the position of the evaporator.

**Solution to Problem**

An evaporator according to an aspect of the present invention is incorporated into a transportation machine to change at least a part of a working fluid from a liquid phase into a gas phase by heat absorbed from a heat-generating element, and includes: a housing including at least one working fluid inlet and at least one working fluid outlet and defining a working fluid-receiving chamber that receives the working fluid; a heat-absorbing element located at a bottom surface of the housing and thermally connected to the heat-generating element; and a wall structure dividing a bottom region of the working fluid-receiving chamber into a plurality of segments to form a plurality of recesses located in the bottom region of the working fluid to trap the working medium.

In the above evaporator, when the bottom surface of the housing is tilted from the horizontal, the liquid-phase working fluid flowing downward along the tilted bottom surface in the working fluid-receiving chamber is blocked by the wall structure and remains in the recesses formed in the bottom region of the working fluid-receiving chamber. Thus, in the event that the evaporator changes its position to have the bottom surface of the housing tilted from the horizontal, the working fluid remains in the bottom region of the working fluid-receiving chamber, and the heat-absorbing element and the working fluid can be kept in thermal contact. Even if the heat-absorbing element has dry portions that are not in contact with the working fluid, the dry portions are distributed over different zones of the heat-generating element with which the heat-absorbing element is in thermal contact, rather than being localized over a particular zone of the heat-generating element. Thus, despite changes in the position of the evaporator, the entire region of the heat-generating element that is in contact with the heat-absorbing element can be cooled efficiently.

A loop heat pipe according to an aspect of the present invention includes: an evaporator that changes at least a part of a working fluid from a liquid phase into a gas phase, the evaporator being as defined above; a condenser that changes the working fluid from the gas phase into the liquid phase; a vapor conduit connecting an outlet of the evaporator and an inlet of the condenser; and a liquid conduit connecting an outlet of the condenser and an inlet of the evaporator.

As previously stated, the evaporator can, despite changes in its position, keep the heat-absorbing element in thermal contact with the working fluid. Thus, the loop heat pipe including the evaporator can avoid a decrease in heat transport rate due to a part of the heat-absorbing element being dry.

**Advantageous Effects of Invention**

The present invention can provide an evaporator including a heat-absorbing element located at the bottom of the evaporator and thermally connected to a heat-generating element and a loop heat pipe including the evaporator, the evaporator and loop heat pipe being adapted to efficiently cool the heat-generating element in contact with the heat-absorbing element.

**Brief Description of Drawings**

FIG. 1 illustrates a schematic configuration of an aircraft incorporating a loop heat pipe according to an exemplary embodiment of the present invention.
FIG. 2 is a perspective view of an evaporator according to a first embodiment.
FIG. 3 is a side view illustrating the internal structure of the evaporator of FIG. 2.
FIG. 4 is a plan view illustrating the internal structure of the evaporator of FIG. 2.
FIG. 5 is a plan view illustrating the internal structure of the evaporator of FIG. 2.
FIG. 6 is a plan view illustrating a variant of the internal structure of the evaporator of FIG. 2.
FIG. 7 illustrates the height of a recess.
FIG. 8 illustrates the evaporator of FIG. 2 which is in a tilted position.
FIG. 9 is a perspective view of an evaporator according to a second embodiment.
FIG. 10 is a side view illustrating the internal structure of the evaporator of FIG. 9.
FIG. 11 illustrates the evaporator of FIG. 9 which is in a tilted position.

**Description of Embodiments**

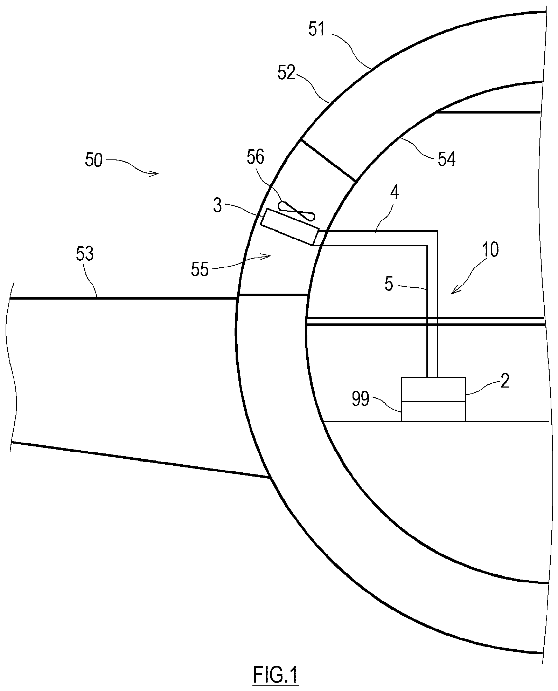

Hereinafter, exemplary embodiments of the present invention will be described with reference to the drawings. FIG. 1 illustrates a schematic configuration of an aircraft 50 incorporating a loop heat pipe 10 according to an exemplary embodiment of the present invention.

The loop heat pipe 10 of FIG. 1 includes an evaporator 2, a vapor conduit 4, a condenser 3, and a liquid conduit 5, which form a closed loop. The closed loop is charged with a working fluid which is a condensable fluid. The working fluid naturally circulates in the loop heat pipe 10 by making use of phase changes and gravity. The working fluid is not limited to particular fluids, and may be a condensable fluid commonly used as a working fluid in heat pipes. Examples of the condensable fluid include water, an alcohol, ammonia, a fluorocarbon, a hydrofluorocarbon, a hydrofluoroether, and a liquid mixture of these fluids.

The evaporator 2 is thermally connected to a heat-generating element 99 serving as a heat source. In this evaporator 2, the working fluid in the liquid phase absorbs heat from the heat-generating element 99, and a part of the working fluid boils and changes into the gas phase. The gas-liquid two-phase working fluid moves in the vapor conduit 4 connecting the outlet of the evaporator 2 and the inlet of the condenser 3 under the action of pressure difference and buoyancy and reaches the condenser 3.

The condenser 3 is located above the evaporator 2. The condenser 3 is provided with a cooling path (not shown), and the two-phase working fluid releases heat and is cooled into the liquid phase during passage through the cooling path. The liquid-phase working fluid descends in the liquid conduit 5 connecting the outlet of the condenser 3 and the inlet of the evaporator 2 under the action of gravity and returns to the evaporator 2.

The loop heat pipe 10 configured as described above is incorporated into a transportation machine. Examples of the transportation machine include watercrafts (including submersibles), railcars, automobiles, and aircrafts. In this exemplary embodiment, the loop heat pipe 10 is incorporated in the aircraft 50 which is an example of the transportation machine. For the aircraft 50, the allowable tilt angle during normal operation is $\alpha°$; that is, the aircraft 50 is permitted to tilt from the horizontal to the allowable tilt angle during normal operation.

FIG. 1 partially shows a fuselage 51 and main wing 53 of the aircraft 50. The fuselage 51 has a multilayer structure including an outer panel 52 and an inner wall 54 located closer to the cabin than the outer panel 52. Between the outer panel 52 and inner wall 54 is defined a cooling chamber 55. The temperature inside the cooling chamber 55 is low because of cold energy transferred from the outer panel 52 which during flight is exposed to outside air having a considerably lower temperature than that near the ground. Alternatively, the outer panel 52 may be provided with an air inlet and air outlet communicating with the cooling chamber 55, and the outside air may be introduced into the cooling chamber 55 during flight.

In the above aircraft 50, the condenser 3 is located in the cooling chamber 55, and the heat-generating element 99 and the evaporator 2 thermally connected to the heat-generating element 99 are closer to the cabin than the inner wall 54. In the cooling chamber 55 is disposed a fan 56 for forcing a gas flow to pass the condenser 3. The condenser 3 condenses the working fluid using cold energy from the outside air. Examples of the heat-generating element 99 include, but are not limited to: an electronic device including heat-generating parts, such as a control board, an engine control unit (ECU), or a computer; a friction heat-generating mechanical part such as a bearing; and a battery. Air inside the cabin may be used as the heat source instead of the heat-generating element 99.

The following describes first and second embodiments of the evaporator 2 of the loop heat pipe 10 configured as described above.

First Embodiment

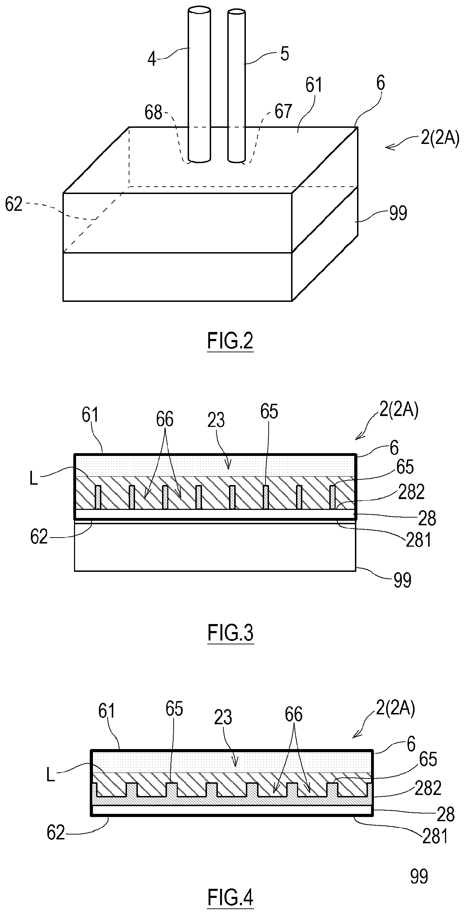

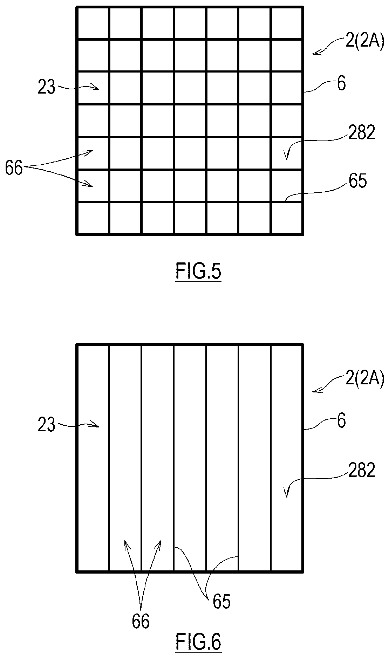

FIG. 2 is a perspective view of an evaporator 2A according to the first embodiment, FIG. 3 is a side view illustrating the internal structure of the evaporator 2A of FIG. 2, FIG. 4 is a plan view illustrating the internal structure of the evaporator 2A of FIG. 2, FIG. 5 is a plan view illustrating a variant of the internal structure of the evaporator 2A of FIG. 2, and FIG. 6 illustrates the evaporator 2A of FIG. 2 which is in a tilted position. As shown in FIGS. 2 and 3, the evaporator 2A according to the first embodiment includes a housing 6, a heat-absorbing element 28 located at the bottom surface 62 of the housing 6, and a wall structure 65 located inside the housing 6.

The housing 6 is in the shape of a rectangular parallelepiped in which top and bottom surfaces 61 and 62 have the largest area. The housing 6 defines a working fluid-receiving chamber 23. Working fluid inlet and outlet 67 and 68 communicating with the working fluid-receiving chamber 23 are located in a central portion of the top surface 61 of the housing 6. The vapor conduit 4 is connected to the working fluid outlet 68, and the liquid conduit 5 is connected to the working fluid inlet 67.

The heat-absorbing element 28 is a plate structure made of a metal material with high thermal conductivity such as copper, and forms a part or all of the bottom surface 62 of the evaporator 2A. The heat-absorbing element 28 includes a heat-absorbing surface 281 facing outside the housing 6 and a boiling surface 282 facing inside the working fluid-receiving chamber 23 of the housing 6. The boiling surface 282 forms the floor surface of the working fluid-receiving chamber 23. The heat-absorbing surface 281 is thermally connected to the heat-generating element 99 located below the evaporator 2A and absorbs heat from the heat-generating element 99.

For example, the wall structure 65 is a plate structure made of a metal material with high thermal conductivity such as copper and rising from the boiling surface 282 of the heat-absorbing element 28 in the working fluid-receiving chamber 23. The wall structure 65 is not limited to metal materials. The wall structure 65 may be in contact with or joined to the boiling surface 282. As shown in FIG. 4, the wall structure 65 may be formed by digging a plurality of recesses 66 in a heat transfer block in contact with the boiling surface 282.

The bottom region of the working fluid-receiving chamber 23 is divided into a plurality of segments by the wall structure 65, and thus the recesses 66 are formed in the bottom region of the working fluid-receiving chamber 23. The recesses 66 can trap the working fluid in the event of tilting of the loop heat pipe 10. The recesses 66 include a plurality of recesses 66 arranged in the direction of tilting movement (tilt direction) of the transportation machine. As shown in FIG. 5, the wall structure 65 may divide the bottom region of the working fluid-receiving chamber 23 into a grid. Alternatively, as shown in FIG. 6, the wall structure 65 may divide the bottom region of the working fluid-receiving chamber 23 into a plurality of rectangular segments arranged in one direction.

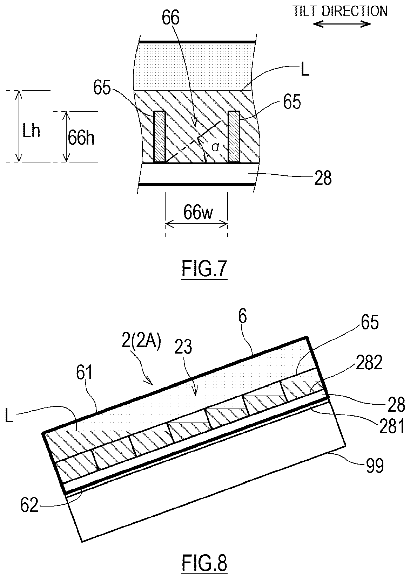

As shown in FIG. 7, the height 66h of each recess 66 (i.e., the height of the wall structure 65) is equal to or greater than the product of the width 66w of the recess 66 which is the dimension of the recess 66 in a direction parallel to the tilt direction of the transportation machine and the tangent of the allowable tilt angle $\alpha$ of the transportation machine, and equal to or smaller than the height Lh to the liquid surface L of the working medium in the working fluid-receiving chamber. That is, the following inequality (1) is satisfied.

$$[\text{Width 66w of recess 66}] \times \tan\alpha \leq [\text{height 66h of recess 66}] \leq [\text{height Lh to liquid}$$

$$\text{surface L of working medium in working fluid-receiving chamber 23}] \qquad (1)$$

In the first embodiment, when the boiling surface 282 is positioned horizontally, the height of the wall structure 65 is smaller than the height to the liquid surface L of the working fluid in the working fluid-receiving chamber 23, and the entire wall structure 65 is below the liquid surface L. If the wall structure 65 is provided with holes via which the adjacent recesses 66 are in communication, the liquid surface L of the working fluid may be below the top of the wall structure 65.

In the evaporator 2A configured as described above, heat absorbed by the heat-absorbing element 28 from the heat-generating element 99 is released to the working fluid through the boiling surface 282 and wall structure 65. At least a part of the working fluid boils under the action of the heat, and the gas-phase or two-phase working fluid fills the inner region of the housing 6 that is above the liquid surface L. In fact, any distinct liquid surface L is not present in a two-phase fluid; however, given that in the working fluid flowing in the housing 6, the volume proportion of the gas present in the liquid increases upward, a boundary plane at which the volume percentage of the gas (void percentage) in the gas-liquid two-phase flow is a given value (e.g., 50%) can be assumed as the liquid surface L.

As described above, the evaporator 2A according to the first embodiment is incorporated into a transportation machine to change at least a part of a working fluid from a liquid phase into a gas phase by heat absorbed from a heat-generating element 99, and includes: a housing 6 including at least one working fluid inlet 67 and at least one working fluid outlet 68 and defining a working fluid-receiving chamber 23 that receives the working fluid; a heat-absorbing element 28 located at a bottom surface 62 of the housing 6 and thermally connected to the heat-generating element 99; and a wall structure 65 dividing a bottom region of the working fluid-receiving chamber 23 into a plurality of segments to form a plurality of recesses 66 located in the bottom region of the working fluid 23 to trap the working medium.

In the evaporator 2A configured as described above, when the bottom surface 62 of the housing 6 is tilted from the horizontal as shown in FIG. 8, the liquid-phase working fluid flowing downward along the tilted bottom surface 62 in the working fluid-receiving chamber 23 is blocked by the wall structure 65 and trapped in the recesses 66. Thus, in the event that the evaporator 2A changes its position to have the bottom surface 62 of the housing 6 tilted from the horizontal, the working fluid remains in the bottom region of the working fluid-receiving chamber 23, and the entire heat-absorbing element 28 can be kept in contact with the working fluid. Even if the heat-absorbing element 28 has dry portions that are not in contact with the working fluid, the dry portions are distributed over different zones of the heat-generating element 99 rather than being localized over a particular zone of the heat-generating element 99. Thus, despite changes in the position of the evaporator 2A, the entire region of the heat-generating element 99 that is in contact with the heat-absorbing surface 281 can be cooled efficiently.

In the above evaporator 2A, as illustrated in the first embodiment, the bottom region of the working fluid-receiving chamber 23 may be divided into a grid by the wall structure 65.

In this case, the flow of the working fluid along the boiling surface 282 can be blocked by the wall structure 65 regardless of the direction in which the evaporator 2A is tilted.

In the above evaporator 2A, as illustrated in the first embodiment, the recesses 66 include a plurality of recesses 66 arranged in a tilt direction of the transportation machine.

In this case, when the evaporator 2A is tilted in response to tilting of the transportation machine, the working fluid in the working fluid-receiving chamber 23 comes into contact with the wall structure 65, by which the flow of the working fluid can be blocked.

In the above evaporator 2A, as illustrated in the first embodiment, the height 66h of the recess 66 may be equal to or greater than the product of the width 66w of the recess 66 which is the dimension of the recess 66 in the tilt direction of the transportation machine and the tangent of the allowable tilt angle $\alpha$ of the transportation machine, and equal to or smaller than the height Lh to the liquid surface L of the working medium in the working fluid-receiving chamber.

Setting the height 66h of the recess 66 in this manner allows the boiling surface 282 of the heat-absorbing element 28 to keep in contact with the working fluid in the event that the evaporator 2A is tilted by an angle equal to or smaller than the allowable tilt angle α of the transportation machine.

The angle α represents the allowable tilt angle up to which the transportation machine incorporating the evaporator 2 can tilt during normal operation. The "normal operation" of the transportation machine refers, for example, to operation performed taking into consideration economic efficiency and safety. The angle α is not limited to the allowable tilt angle, and may be any one of a maximum value, a recommended value, and an average value of the angle of tilt of the transportation machine with respect to the horizontal. The range of tilting movement during normal operation varies for different transportation machines. For aircrafts, the allowable limit of the pitch angle may be about 15°, and the allowable limit of the roll angle (bank angle) may be about 30°. For railcars, the allowable tilt angle with respect to a horizontal plane may be from about 2 to 5°. For watercrafts other than submersibles, the allowable limit of the pitch angle may be about 25°, and the allowable limit of the roll angle may be 25°. For roads on which automobiles travel, the maximum tilt angle is about 20° (about 40%). Since, as described above, the range of tilting movement varies for different transportation machines, a suitable value of the angle α may be chosen depending on the type of the transportation machine. Given that the allowable tilt angle during normal operation is not greater than 30° for most transportation machines, the value of the angle α may be set to 30 irrespective of the range of tilting movement of the transportation machine. The angle α is not limited to the allowable tilt angle, and may be any one of a maximum value, a recommended value, and an average value of the angle of tilt of the transportation machine with respect to the horizontal.

The loop heat pipe 10 according to an exemplary embodiment includes: the evaporator 2A that changes at least a part of a working fluid from a liquid phase into a gas phase; a condenser 3 that changes the working fluid from the gas phase into the liquid phase; a vapor conduit 4 connecting an outlet of the evaporator 2A and an inlet of the condenser 3; and a liquid conduit 5 connecting an outlet of the condenser 3 and an inlet of the evaporator 2A.

As previously stated, the evaporator 2A can, despite changes in its position, keep the boiling surface 282 in contact with the working fluid. Thus, the loop heat pipe 10 including the evaporator 2A can avoid a decrease in the rate of heat transport from the heat-absorbing element 28 to the liquid-phase working fluid.

Second Embodiment

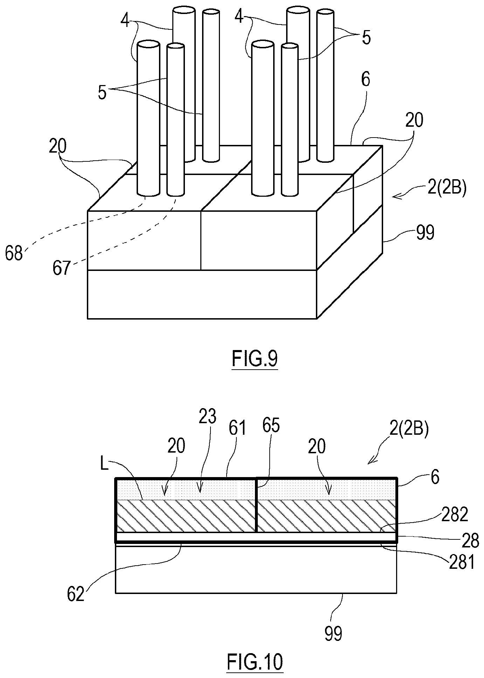

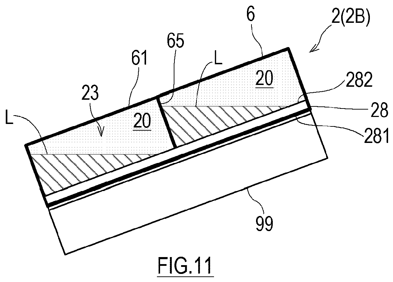

Next, an evaporator 2B according to the second embodiment will be described. FIG. 9 is a perspective view of the evaporator 2B according to the second embodiment, FIG. 10 is a side view illustrating the internal structure of the evaporator 2B of FIG. 9, and FIG. 11 illustrates the evaporator 2B of FIG. 9 which is in a tilted position. For the second embodiment, the elements which are the same as or similar to those of the first embodiment described above are denoted by the same reference signs in the figures, and will not be described below.

As shown in FIGS. 9 and 10, the evaporator 2B according to the second embodiment is in the shape of a rectangular parallelepiped in which top and bottom surfaces 61 and 62 have the largest area, and includes: a housing 6 defining a working fluid-receiving chamber 23; a heat-absorbing element 28 located at a bottom surface 62 of the housing 6 and including a heat-absorbing surface 281 facing outside the housing 6 and a boiling surface 282 facing inside the working fluid-receiving chamber 23; and a wall structure 65 rising from the boiling surface 282 in the working fluid-receiving chamber 23 and dividing the working fluid-receiving chamber 23 into a plurality of segments. Although in FIGS. 9 and 10 the evaporator 2B includes a single heat-absorbing element 28 shared by the plurality of segments of the evaporator 2B, the evaporator 2B may include a plurality of heat-absorbing elements 28 respectively associated with the different segments.

The evaporator 2B according to the second embodiment is characterized in that the wall structure 65 extends from the boiling surface 282 to the ceiling of the working fluid-receiving chamber 23 and that the working fluid-receiving chamber 23 is divided into a plurality of separate cells (hereinafter referred to as "evaporation cells 20") by the wall structure 65. The vapor and liquid conduits 4 and 5 are connected to the top surface 61 of each evaporation cell 20, and the evaporation cell 20 functions alone as an evaporator.

In the evaporator 2B configured as described above, when the boiling surface 282 is tilted from the horizontal as shown in FIG. 11, the liquid-phase working fluid flows downward along the tilted boiling surface 282 in the working fluid-receiving chamber 23. Thus, some regions of the boiling surface 282 become dry portions which are located above the liquid surface L of the working fluid and not in contact with the working fluid. However, in the evaporator 2B, the working fluid-receiving chamber 23 of which is divided into the plurality of evaporation cells 20, the dry portion is present in each evaporation cell 20. Thus, the dry portions are distributed over different zones of the heat-generating element 99 in contact with the heat-absorbing surface 281, rather than being localized over a particular zone of the heat-generating element 99. As such, despite changes in the position of the evaporator 2B, the entire region of the heat-generating element 99 that is in contact with the heat-absorbing surface 281 can be cooled efficiently. Further, in the working fluid-receiving chamber 23 divided into the evaporation cells 20, the sum of the areas of the dry portions in the evaporation cells 20 is smaller than the sum of the areas of the dry portions which would appear when the working fluid-receiving chamber 23 is not divided into the evaporation cells 20. Thus, a decrease in the rate of heat transport from the heat-generating element 99 to the evaporator 2 can be avoided.

The evaporator 2B according to the second embodiment can constitute a part of the loop heat pipe 10 like the evaporator 2A according to the first embodiment described above. Thus, as with the case of the above embodiment, the loop heat pipe 10 including the evaporator 2B can, despite changes in its position, avoid a decrease in the rate of heat transport from the heat-absorbing element 28 to the liquid-phase working fluid.

Although the foregoing has described preferred embodiments of the present invention, the scope of the present invention embraces modifications made to the details of the structures and/or functions of the above embodiments without departing from the concept of the present invention.

For example, the loop heat pipes 10 of the above embodiments are not limited to the thermosyphon type, and may be of the wick type. The loop heat pipe of the wick type uses not only the capillary force acting on the working fluid in the wick but also gravity to return the working fluid from the condenser 3 to the evaporator 2. Thus, the present invention can offer the benefits as described above also when applied to a heat transport system including a loop heat pipe of the wick type.

**Reference Signs List**

2, 2A, 2B: evaporator
3: condenser
4: vapor conduit
5: liquid conduit
6: housing
10: loop heat pipe
20: evaporation cell
23: working fluid-receiving chamber
28: heat-absorbing element
61: top surface
62: bottom surface
65: wall structure
66: recess
67: working fluid inlet
68: working fluid outlet
99: heat-generating element
281: heat-absorbing surface
282: boiling surface

**Claims**

1. An evaporator incorporated into a transportation machine to change at least a part of a working fluid from a liquid phase into a gas phase by heat absorbed from a heat-generating element, comprising:

    a housing including at least one working fluid inlet and at least one working fluid outlet and defining a working fluid-receiving chamber that receives the working fluid;
    a heat-absorbing element located at a bottom surface of the housing and thermally connected to the heat-generating element; and
    a wall structure dividing a bottom region of the working fluid-receiving chamber into a plurality of segments to form a plurality of recesses located in the bottom region of the working fluid to trap the working medium.

2. The evaporator according to claim 1, wherein the bottom region of the working fluid-receiving chamber is divided into a grid by the wall structure.

3. The evaporator according to claim 1 or 2, wherein the recesses include a plurality of recesses arranged in a tilt direction of the transportation machine.

4. The evaporator according to any one of claims 1 to 3, wherein
a height of the recess is equal to or greater than a product of a dimension of the recess in a tilt direction of the transportation machine and a tangent of an allowable tilt angle of the transportation machine and equal to or smaller than a height to a liquid surface of the working medium in the working fluid-receiving chamber.

5. The evaporator according to any one of claims 1 to 3, wherein the working fluid-receiving chamber is divided into a plurality of separate cells by the wall structure.

6. A loop heat pipe comprising:

an evaporator that changes at least a part of a working fluid from a liquid phase into a gas phase, the evaporator being according to any one of claims 1 to 5;
a condenser that changes the working fluid from the gas phase into the liquid phase;
a vapor conduit connecting an outlet of the evaporator and an inlet of the condenser; and
a liquid conduit connecting an outlet of the condenser and an inlet of the evaporator.

<u>FIG.1</u>

FIG.2

FIG.3

FIG.4

FIG.5

FIG.6

TILT DIRECTION

66

65

L

65

Lh

66h

α

28

66w

FIG.7

6

65

2(2A)

23

282

61

28

281

L

99

62

FIG.8

FIG.9

FIG.10

FIG.11

## INTERNATIONAL SEARCH REPORT

| International application No. |
|---|
| PCT/JP2019/050599 |

### A. CLASSIFICATION OF SUBJECT MATTER
Int. Cl. R01L23/427(2006.01)i, F28D15/02(2006.01)i, H05K7/20(2006.01)i

According to International Patent Classification (IPC) or to both national classification and IPC

### B. FIELDS SEARCHED

Minimum documentation searched (classification system followed by classification symbols)
Int. Cl. H01L23/427, F28D15/02, H05K7/20

Documentation searched other than minimum documentation to the extent that such documents are included in the fields searched
```
Published examined utility model applications of Japan    1922-1996
Published unexamined utility model applications of Japan  1971-2020
Registered utility model specifications of Japan          1996-2020
Published registered utility model applications of Japan  1994-2020
```

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2006-114603 A (TOSHIBA CORP.) 27 April 2006, paragraphs [0019], [0020], [0026], [0027], [0035], [0036], fig. 3, 4, 7 (a)-7 (b) | 1-6 |
| Y | JP 2013-32904 A (PANASONIC CORP.) 14 February 2013, paragraphs [0017], [0020], fig. 3 | 1-6 |
| Y | JP 2004-48489 A (MITSUBISHI ELECTRIC CORP.) 12 February 2004, paragraphs [0126], [0127], fig. 16 (a)-16 (b) | 2-6 |
| A | DE 102012111489 A1 (DR. ING. H.C. F. PORSCHE AKTIENGESELLSCHAFT) 28 May 2014, fig. 1, 2 | 1, 3-4 |

☐ Further documents are listed in the continuation of Box C.    ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 05.02.2020 | 18.02.2020 |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

Information on patent family members

International application No.

PCT/JP2019/050599

| Patent Documents referred to in the Report | Publication Date | Patent Family | Publication Date |
|---|---|---|---|
| JP 2006-114603 A | 27.04.2006 | (Family: none) | |
| JP 2013-32904 A | 14.02.2013 | WO 2013/001735 A1 | |
| JP 2004-48489 A | 12.02.2004 | (Family: none) | |
| DE 102012111489 A1 | 28.05.2014 | (Family: none) | |

Form PCT/ISA/210 (patent family annex) (January 2015)

**EP 3 905 321 A1**

## REFERENCES CITED IN THE DESCRIPTION

**Patent documents cited in the description**

- JP 5741354 B